# EUROPÄISCHE PATENTANMELDUNG

(11) **EP 0 703 606 A2**
(43) Veröffentlichungstag der Anmeldung: **27.03.1996**
(21) Anmeldenummer: 95114752.9
(22) Anmeldetag: 19.09.1995
(51) Int. Cl.: H01L 21/321, H01J 37/32

(54) **Verfahren zur Vermeidung der Re-Deposition von Ätzprodukten auf Substratoberflächen während des Wolfram-Rückätzprozesses bei der Herstellung hochintegrierter Schaltungen**

(30) Priorität: 20.09.1994 DE 4433538
(71) Anmelder: SIEMENS AKTIENGESELLSCHAFT, D-80333 München (DE)
(72) Erfinder: Braun, Rainer, D-81549 München (DE); Seidel, Uwe, D-81737 München (DE)

(57) **Zusammenfassung**

Während der Rückätzung wird das Substrat mittels eines am Substratrand angeordneten Halteringes gegen einen gekühlten Probenaufnehmer gedrückt. Dieser Haltering ist erfindungsgemäß so modifiziert, daß der Substratrand nur lokal durch den an diesen Stellen rückstaufrei gegenüber den bei der Rückätzung freiwerdenden Ätzprodukten ausgebildeten Haltering gehalten wird, so daß die Ätzprodukte an den Haltestellen vorbeiströmen und gezielt außerhalb der Substratoberfläche abgeschieden werden.

## Beschreibung

Die Erfindung betrifft ein Verfahren zur Rückätzung von mit Wolfram beschichteten Substratoberflächen bei der Herstellung hochintegrierter Schaltungen, bei dem das Substrat während der Rückätzung mittels eines am Substratrand angeordneten Halteringes gegen einen gekühlten Probenaufnehmer gedrückt wird.

In Mikroelektronikbausteinen sind die verschiedenenen leitenden Schichten, beispielsweise dotiertes Siliziumsubstrat, Polysilizium oder Metallbahnen durch Isolatoren (z. B. SiO₂) voneinander getrennt. Um funktionsfähige Schaltungen zu erhalten, müssen die einzelnen leitenden Schichten an geeigneten Stellen untereinander kontaktiert werden. In der Regel werden hierzu in die Isolatoren Löcher, sogenannte Kontaktlöcher bzw. Vias, geätzt, in die dann ebenfalls leitendes Material eingebracht wird. In der sub-µm Technologie hat sich als geeignetes Verfahren die Auffüllung dieser Löcher mit chemisch aus der Gasphase abgeschiedenem Wolfram (CVD-W) durchgesetzt. Eine bekannte Vorgehensweise besteht zunächst in der Abscheidung einer CVD-W Schicht aus Wolframhexafluorid WF₆ und H₂ oder SiH₄. Diese Schicht wird auf eine TiN- oder TiW-Unterlage (Haftschicht, Barriere) abgeschieden und wächst auf der gesamten Substratoberfläche sowie dem Lochboden und den -seitenwänden auf, bis im Falle des Letztgenannten die Schicht zusammenwächst. In einem nachfolgenden Schritt, der Ruckätzung, wird die zuvor auf der horizontalen Substratoberfläche abgeschiedene leitende Schicht wieder vollständig entfernt, so daß im Idealfall die mit leitendem Material komplett aufgefüllten Kontaktlöcher oder Vias zurückbleiben.

Bei der Wolfram-Rückätzung ist es erforderlich, daß das Substrat mittels einer Haltevorrichtung, dem Halte- oder Clamp-Ring, gegen einen gekühlten Probenaufnehmer (Pedestal) gedrückt wird. Durch Bearbeitungstoleranzen und Oberflächenrauhigkeiten ergibt sich nämlich zwischen Pedestal und Substrat ein mikroskopischer Hohlraum bzw. Spalt, der für eine gute Substratkühlung schädlich ist. Zur besseren Kühlung des Substrats wird deshalb der Hohlraum zwischen Substrat und Pedestal mit Helium gefüllt, welches durch das Pedestal zugeführt wird. Damit kein Helium auf die Substrat-Vorderseite gelangt, und damit das Subtrat durch das eingespeiste Helium nicht vom Pedestal weggedruckt wird, wird das Substrat mit einem Haltering gegen den Probenaufnehmer gedrückt, wobei dieser Haltering bisher so konstruiert ist, daß er das Substrat vollkommen umschließt. Der Rückätzschritt wird typischerweise in einem F- und/oder Cl-haltigen Plasma ausgeführt, wobei die wichtigsten Einflüsse der Prozeßparameter auf verschiedene Zielgrößen an sich bereits bekannt sind.

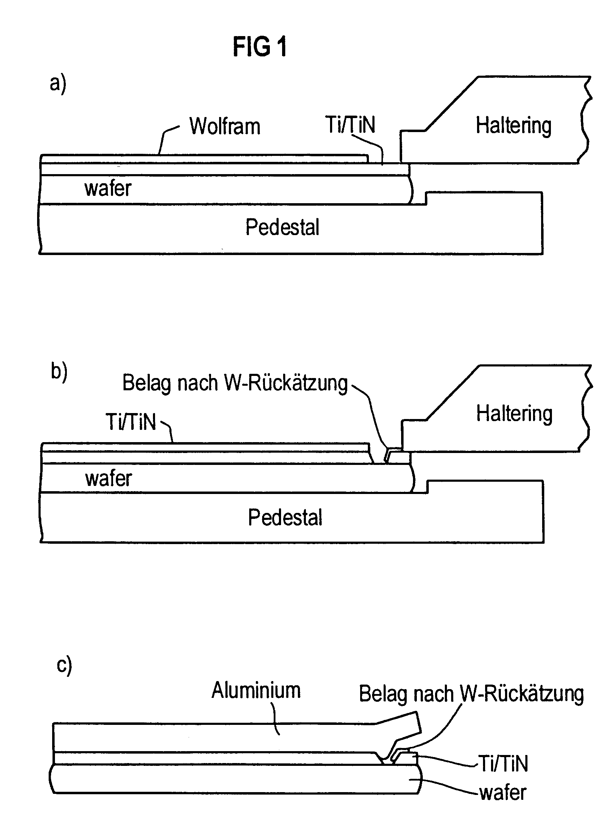

Mit diesem bekannten Verfahren wird nicht nur eine Auffüllung der Kontaktlöcher oder Vias mit leitendem Material angestrebt, sondern auch eine Substratoberfläche, die nach der Wolfram-Rückätzung frei von Wolfram-Resten ist. Diese Anforderung an den Rückätzprozeß, das leitende Material vollständig von der Substratoberfläche zu entfernen, ist wichtig, um Kurzschlüsse zwischen nachfolgend erzeugten Bahnen zu vermeiden. Um diese Wolfram-Restefreiheit zu erreichen, wird der Rückätzschritt zeitlich verlängert, d.h. es wird überätzt bis die Oberfläche der TiN- oder TiW-Unterlage (Haftschicht, Barriere) frei von Wolfram-Resten ist. Durch diese Überätzung wird die Haftschicht gedünnt, und z.T. lokal sogar vollständig entfernt, insbesondere im Randbereich. Die dabei freiwerdenden Ätzprodukte schlagen sich auf dem Substratrand nieder. Dieser Niederschlag konzentriert sich, wie aus Figur 1 ersichtlich, in einem Bereich der Subtrathaltevorrichtung, der unmittelbar mit dem Substrat in Berührung kommt. Wird das Substrat nun nach Beendigung des Rückätzprozesses an Atmosphäre gebracht, vermischt sich der Niederschlag mit dem in der Raumluft enthaltenden Sauerstoff. Dieses Gemisch wird auch in nachfolgenden Arbeitsschritten (z.B. Wasserspülung), die im weiteren Prozeßablauf enthalten sind, nicht mehr entfernt.

Werden anschließend, wie in Figur 1 angedeutet, weitere leitende oder nichtleitende Schichten ganzflächig aufgebracht, so kommt es im Bereich des "Niederschlags", also der Re-Deposition, zu Schichtablösungen in Folge der Spannungen der aufgebrachten Schichten. Die unerwünschten und störenden Schichtablösungen stellen eine "Partikelbelastung" für die Substratoberfläche dar. Diese Partikelbelastung führt zu Ausbeuteeinbußen und Substratverwurf.

Nach der W-Rückätzung wurde bisher der "Niederschlag" (Re-Deposition) durch langdauernde Wasserspülungen entfernt. Der Erfolg dieser Wasserspülungen war nicht reproduzierbar, zugleich sollten Wasserspülungen an Metallschichten weitgehend vermieden und in ihrer Dauer eingeschränkt sein. Auch Prozeßumstellungen in der Überätzphase die den Niederschlag reduzieren sollten und in Situ-Plasmareinigungsschritte, die dem W-Rückätzprozeß folgten, führten nicht zum Erfolg.

Der vorliegenden Erfindung liegt daher die Aufgabe zugrunde, ein Verfahren der eingangs angegebenen Art zu schaffen, das Probleme mit der geschilderten unerwünschten Re-Deposition vermeiden hilft.

Diese Aufgabe wird erfindungsgemäß dadurch gelöst, daß der Substratrand nur lokal an über den Umfang verteilten Haltestellen durch den Haltering gehalten wird , und daß diese Haltestellen rückstaufrei gegenüber den bei der Rückätzung freiwerdenden Ätzprodukten ausgebildet sind, so daß die Ätzprodukte an den Haltestellen vorbeiströmen und gezielt außerhalb der Substratoberfläche abgeschieden werden.

Weiterbildungen der Erfindung sind Gegenstand von Unteransprüchen.

Im folgenden wird die Erfindung anhand eines Ausführungsbeispiels und den Figuren der Zeichnung noch näher erläutert. Es zeigt:
- Figur 1a, b, c: in dieser Reihenfolge die Resultate der aufeinanderfolgenden Prozeßschritte
a)Wolfram-Abscheidung und
b)Rückätzung und anschließende
c) Al-Metallisierung,
- Figur 2: eine geschnittene Seitenansicht eines erfindungsgemäß durch einen Haltering gehaltenen Substrats,
- Figur 3: Einzelheiten der Haltestellen des Halterings gemäß Figur 2.

Der Erfindung liegt die Erkenntnis zugrunde, daß das schädliche Abscheideverhalten ausschließlich dem Substrathalter zuzuschreiben ist und daß sich der beschriebene Effekt des Niederschlags von Ätzprodukten auf der Substratoberfläche in unmittelbarer Umgebung eines Substrathalterings gänzlich vermeiden läßt, indem der Substrathaltering so abgeändert wird, daß die Ätzprodukte gezielt außerhalb der Substratoberfläche abgeschieden werden. Dies erreicht man dadurch, daß der Haltering so ausgearbeitet wird, daß das Substrat nur noch lokal oder punktuell durch den Substrathalter gehalten wird. Man könnte sagen, daß das Substrat erfindungsgemäß nur noch von einzelnen "Fingern" gehalten wird. Für ein gezieltes Abscheiden der unerwünschten Ätzprodukte außerhalb des Substrats, sind die Form und die Dimensionen der Finger und des Halterings entscheidend.

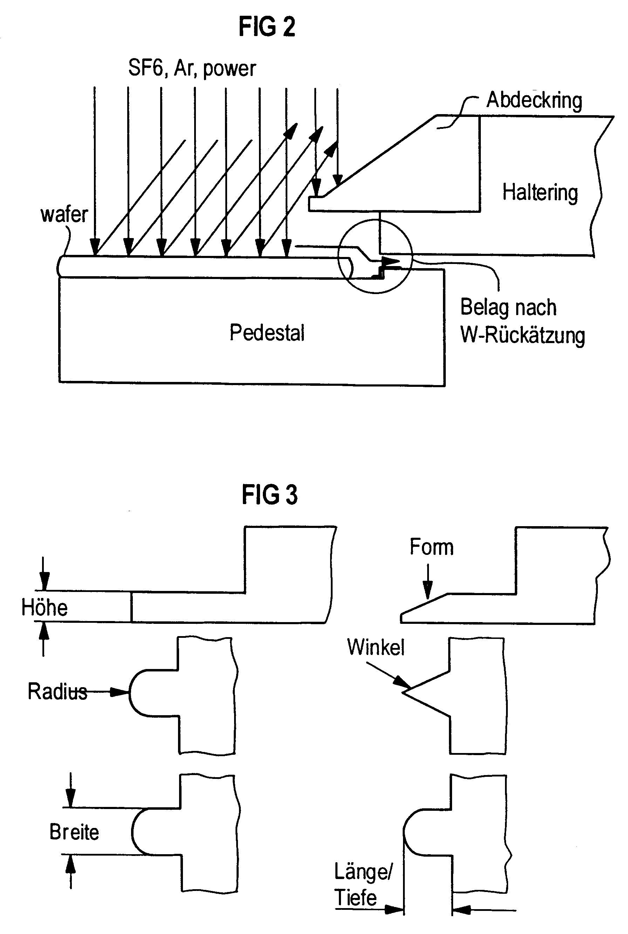

Am Haltering sollten mindestens drei der sich fingerförmig bis zum Substratrand erstreckenden Haltestellen vorgesehen werden. Eine größere Zahl, beispielsweise 24 über den Umfang verteilte Haltestellen, ist eher vorteilhaft. Auch eine kammartig ausgebildete Vielzahl von Haltestellen kommt in Frage. In der geschnittenen Ansicht gemäß Figur 2 ist zur besseren Verständlichkeit das vordere, bis auf den Substratrand reichende Ende der fingerförmigen Haltestelle nur durch ein leeres Rechteck angedeutet worden; das an den Haltestellen vorbei -bzw. zwischen ihnen hindurchstromende Ätzgas/-produkte lagert sich wie dargestellt gezielt außerhalb der Substratoberfläche ab. Dieser Vorgang soll durch die Kreismarkierung in Figur 2, die ansonsten keine Bedeutung hat, nur betont werden. Ein Rückstau der Ätzprodukte an den Haltestellen, der zu einer unerwünschten Ablagerung dort führen würde, kann durch die in Figur 3 dargestellte Formung der Haltestellen, die an ihren substratseitigen Enden spitz zulaufend oder bogenförmig abgerundet ausgebildet werden, vermieden werden. Für die fingerförmigen Haltestellen sollte eine Breite, Höhe und Länge von höchstens wenigen Millimetern gewählt werden, insbesondere sollte die Breite und Höhe im Bereich von etwa 2 mm liegen. Bei zu schmalen Haltestellen würde lokal eine zu große Haltekraft auf den Wafer wirken, so daß sich einBeschädigungsrisiko ergäbe. Bei zu großer Länge müßte das Gas zu weit strömen, andererseits ist eine Mindesthöhe erforderlich, damit das Gas ungehindert durchströmen kann. Zur Vermeidung von Rückstau ist es vorteilhaft, die fingerförmigen Haltestellen zu ihren substratseitigen Enden hin abzuflachen.

In Figur 2 ist auch ein zusätzlicher, auf dem Haltering aufliegender Abdeckring dargestellt, der den Substratrand mit Abstand überdeckt. Dieses Verschleißteil schützt den Haltering bzw. das Pedestal vor dem Plasmaeinfluß.

Die entscheidenden Dimensionen und Formen (Breite, Höhe, Radius, Winkel und Länge der Finger) für die Herstellung eines Halterings sind in Figur 3 dargestellt.

Für die Anfertigung eines Substrathalterings wird vom Material her eine Aluminiumoxidkeramik bevorzugt, andere Materialien wie z.B. plasmaresistende Kunststoffe oder Aluminium könnten auch verwendet werden, so lange sie typische Materialien sind, die in der Plasmaätzung ihre Anwendung finden. Für das angestrebte Ergebniss ist jedoch ausschließlich die Gestaltung des Substrathalterings, die Kombination der oben angegebenen Dimensionen und Formen untereinander, und der Abstand der Haltefinger zueinander wichtig. Erfindungsgemäß kann der Substrathaltering beispielsweise in einer CVD- und Rückätzanlage des Typs AMT P5000 der Firma Applied Materials zum Einsatz kommen.

Folgende Parameter und Prozeßeigenschaften können angewendet werden:
a) Sicherstellung einer effektiven Wafer-Kühlung, so daß die tatsächliche Wafer-Temperatur auch während des Plasma-Ätzprozesses 70 °C nicht übersteigt und idealerweise < 40 °C ist. Dabei ist das Gelingen des Verfahrens nicht abhängig von der Art und Weise der Waferkühlung selbst. Zwischen dem Wafer und der gekühlten Ablage (Pedestal) kann entweder ein statischer Helium-Druck von 5 - 50 Torr aufgebaut werden oder ein dynamischer Helium-Fluß eingestellt werden.
b) Eine geeignet ausgewählte Mischung der Ätzgase. Bewährt haben sich Mischungen aus Schwefelhexafluorid SF₆ oder alternativ CF₄, CHF₃, C2F₆ und einem oder mehrerem der Inertgase He, Ar, N₂. Sauerstoff kann dem Ätzgasgemisch zugegeben werden, ist aber bei Verwendung von SF₆ zum Gelingen nicht notwendig
c) Eine geeignete Wahl der Parameter "Gesamtdruck" und "Gesamtgasfluß" derart, daß die Ätzreaktion im Regime der transport- oder diffusionskontrollierten Kinetik stattfindet.
d) Die bevorzugte Gestaltung der Oberflächen der umgebenden Materialien in der Ätzkammer aus Aluminium oder Keramik und damit aus Materialien, die nicht Ätzradikale binden oder verbrauchen.

Als typisches Ausführungsbeispiel für MERIE-(Magnetically enhanced reactive ion etching) Ätzen von Wolfram seien folgende Parameter angegeben:

| | typischer Bereich | idealer Bereich |
|---|---|---|
| Plasmaleistung (W) | 50 - 1000 | 150 - 600 |
| Druck (mTorr) | 5 - 500 | 50 - 300 |
| SF₆-Fluß (sccm) | 10 - 500 | 50 - 250 |
| Inertgas (He,Ar,N₂; sccm) | 0 - 500 | 20 - 200 |
| Pedestal-Temperatur (° C) | 5 - 70 | 15 - 40 |
| He-Kühlgasfluß (sccm) | 5 - 100 | 10 - 50 |
| Magnetfeld (Gauss) | 0 - 300 | 0 - 100 |

## Patentansprüche

1. Verfahren zur Rückätzung von mit Wolfram beschichteten Substratoberflächen bei der Herstellung hochintegrierter Schaltungen, bei dem das Substrat während der Rückätzung mittels eines am Substratrand angeordneten Halteringes gegen einen gekühlten Probenaufnehmer gedrückt wird,
**dadurch gekennzeichnet**,
daß der Substratrand nur lokal an über den Umfang verteilten Haltestellen durch den Haltering gehalten wird , und daß diese Haltestellen rückstaufrei gegenüber den bei der Rückätzung freiwerdenden Ätzprodukten ausgebildet sind, so daß die Ätzprodukte an den Haltestellen vorbeiströmen und gezielt außerhalb der Substratoberfläche abgeschieden werden.

2. Verfahren nach Anspruch 1,
**dadurch gekennzeichnet,**
daß am Haltering mindestens drei sich fingerförmig bis zum Substratrand erstreckende Haltestellen vorgesehen werden.

3. Verfahren nach Anspruch 2,
**dadurch gekennzeichnet,**
aß die Haltestellen an ihren substratseitigen Enden spitz zulaufend oder bogenförmig abgerundet ausgebildet werden.

4. Verfahren nach Anspruch 2 oder 3,
**dadurch gekennzeichnet,**
daß für die fingerförmigen Haltestellen eine Breite, Höhe und Länge von höchstens wenigen Millimetern gewählt wird und das die Breite und Höhe insbesondere im Bereich von etwa 2mm gewählt werden.

5. Verfahren nach einem der Ansprüche 1 bis 5,
**dadurch gekennzeichnet,**
daß die fingerförmigen Haltestellen zu ihren substratseitigen Enden hin abgeflacht sind.

6. Verfahren nach einem der Ansprüche 2 bis 4,
**dadurch gekennzeichnet,**
daß ein zusätzlicher, auf dem Haltering aufliegender Abdeckring vorgesehen wird, der den Substratrand mit Abstand überdeckt.
